# EUROPEAN PATENT APPLICATION

(11) **EP 1 686 635 A1**
(43) Date of publication of application: **02.08.2006**
(21) Application number: 05106012.7
(22) Date of filing: 01.07.2005
(51) Int. Cl.: H01L 51/52, H01L 51/56

(54) **Method of forming thin film and method of fabricating OLED**

(30) Priority: 31.01.2005 KR 2005008791
(71) Applicant: Samsung SDI Co., Ltd., Suwon-si Gyeonggi-do (KR)
(72) Inventor: Kim, Do-Geun, Yeongtong-gu, Suwon-si, Gyeonggi-do (KR); Kim, Han-Ki, Yeongtong-gu, Suwon-si, Gyeonggi-do (KR); Huh, Myung-Soo, Yeongtong-gu, Suwon-si, Gyeonggi-do (KR)
(74) Representative: Hengelhaupt, Jürgen

(57) **Abstract**

A method of forming a thin film and a method of fabricating an organic light emitting display device are provided. The method includes depositing a film formation material (140) mixed with a deposition material (122) and an additive material (123) to form the thin film, and the additive material has a eutectic melting point with the deposition material. Accordingly, it is possible to form the thin film at a quite lower temperature compared to a conventional case of forming the thin film using only a deposition material.

## Description

### CROSS-REFERENCE TO RELATED APPLICATION

This application claims priority to and the benefit of Korean Patent Application No. 2005-8791, filed January 31 2005, which is incorporated herein by reference in its entirety.

### BACKGROUND OF THE INVENTION

### 1. Field of the Invention

The present invention relates to a method of forming a thin film and a method of fabricating an organic light emitting display device (OLED) and, more particularly, to a method of forming the thin film at low temperature by depositing an additive material having a eutectic melting point with a deposition material, and a method of fabricating an OLED.

### 2. Description of the Related Art

In general, methods of forming a thin film on a substrate include a physical vapor deposition (PVD) method such as a vacuum deposition method, an ion-plating method and a sputtering method, and a chemical vapor deposition (CVD) method using gas reaction, and so forth. Among these methods, a vacuum deposition method is mainly employed to form a thin film such as an organic layer and an electrode or the like in the OLED.

The vacuum deposition method is a method of disposing an evaporation source at a lower side of a vacuum deposition chamber and a substrate for film formation at an upper side thereof to form a thin film. The vacuum deposition method includes a resistance heating deposition method, an electron beam deposition method, an induction heating deposition method, and so forth. An effusion cell of the guided heat deposition method (or an indirect heat deposition method) is mainly used as the evaporation source used for the vacuum deposition method.

The above-described methods of forming the thin film are employed to form various thin films which constitute the OLED. The OLED is a self emissive display device in which electrons and holes injected into an organic thin film through a cathode electrode and an anode electrode are recombined to form excitons, and light having a specific wavelength is resultantly emitted by energy resulted from the exitons. The OLED has advantages that it can be driven by a low voltage, and it is light weight and very thin and has a wide viewing angle and a fast response speed.

Such an OLED is comprised of an anode electrode, an organic layer, and a cathode electrode which are stacked on a substrate. The organic layer includes an organic light emitting layer, and may further include an electron transport layer, a hole transport layer, a hole injection layer, and an electron injection layer.

The cathode electrode may be formed of a metal, and in particular, may be formed of aluminum (Al) having a low work function. A high heat source is required to form the Al layer. That is, a large amount of energies are required to form the thin film such as Al and degradation on the substrate due to a high temperature process may occur.

### SUMMARY OF THE INVENTION

The present invention, therefore, provides a method of forming a thin film capable of forming a film at a low temperature without requiring a high temperature heat source, and enhancing mechanical and electrical properties of the thin film to be formed, and a method of fabricating an OLED.

In an exemplary embodiment of the present invention, a method of forming a thin film is provided. The method includes depositing a film formation material mixed with a deposition material and an additive material to form the thin film, and a material having a eutectic melting point with the deposition material is used as the additive material. Accordingly, it is possible to form the thin film at a quite lower temperature than a conventional case of forming the thin film using only a deposition material.

The thin film to be formed may be an Al alloy, and may be used as an electrode. The thin film may be formed using a vacuum deposition method.

In another exemplary embodiment of the present invention, a method of fabricating an OLED is provided. The method includes forming a first electrode on a substrate. An organic layer including at least an organic light emitting layer is formed on the first electrode. The method includes forming a second electrode on the organic layer pattern, and at least one of the first and second electrodes is formed by depositing a film formation material mixed with a deposition material and an additive material having a eutectic melting point with the deposition material.

Al may be employed as the deposition material for forming the second electrode. The second electrode may be a cathode electrode, and the cathode electrode to be formed may be comprised of an Al alloy. At least one of the first and second electrodes may be formed using a vacuum deposition method. The deposition material may employ metals or inorganic materials, and may use Al among the metals.

The additive material may employ metal materials or non-metal materials. A material having a work function equal to or less than Al may be used as the additive material, and in particular, one of silicon (Si), magnesium (Mg), and calcium (Ca) may be used for the same.

### BRIEF DESCRIPTION OF THE DRAWINGS

The above and other features of the present invention will be described in reference to certain exemplary embodiments thereof with reference to the attached drawings in which:
FIG. 1A is a schematic plan view illustrating a method of forming a thin film according to the present invention;
FIG. 1B is a cross-sectional view illustrating an evaporation source used in forming a thin film according to the present invention;
FiGs. 2A to 2C are phase diagrams of film formation materials mixed with a deposition material and an additive material according to the present invention; and
FIG. 3 is a schematic view illustrating a method of fabricating an OLED according to the present invention.

### DETAILED DESCRIPTION OF THE INVENTION

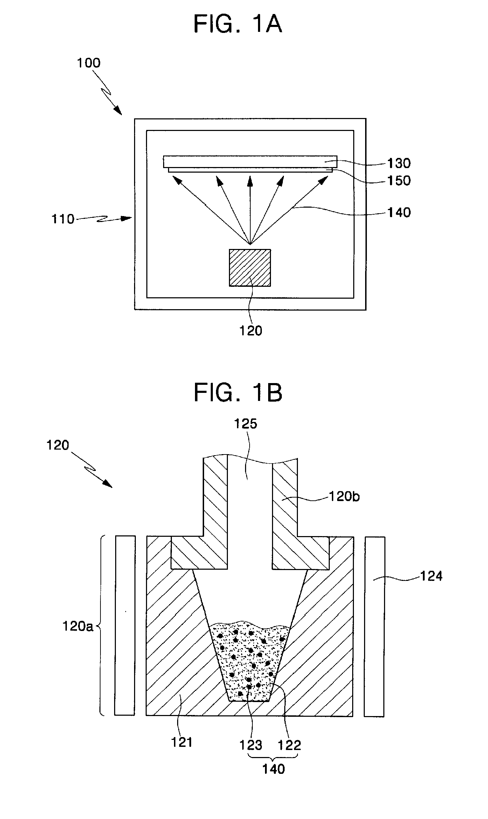

FIG. 1A is a schematic plan view illustrating a method of forming a thin film according to the present invention, and FIG. 1B is a cross-sectional view illustrating an evaporation source used in forming a thin film according to the present invention.

Referring to FIGs. 1A and 1B, the method of forming a thin film according to the present invention is illustrated using a vacuum deposition method. A vacuum deposition apparatus 100 used for the vacuum deposition method includes a vacuum deposition chamber 110, an evaporation source 120, a substrate 130, and so forth. The evaporation source 120 may be composed of an evaporation unit 120a evaporating a desired material to be deposited on the substrate 130, and a nozzle unit 120b spraying gases evaporated from the evaporation unit 120a.

A vacuum exhaust system (not shown) connected to the vacuum deposition chamber 110 is present, which is employed to maintain an inside of the vacuum deposition chamber 110 in a constant vacuum state. A furnace 121 of the evaporation source 120 disposed at a lower side of the vacuum deposition chamber 110 is then heated using a heat line 124. When the heat is applied to the furnace 121, it is also applied to the film formation material 140 and then evaporated.

The evaporated film formation material 140 passes through a hole 125 of the nozzle unit 120b to reach the substrate 130 spaced from an upper side of the evaporation source 120 by a predetermined distance. Accordingly, the film formation material 140 evaporated from the furnace 121 of the evaporation source 120 reaches the substrate 130, which is solidified on the substrate 130 through successive steps of absorption, deposition, re-evaporation or the like, thereby forming a thin film 150.

The film formation material 140 is accommodated in the furnace 121, which includes a deposition material 122 and an additive material 123.

Inorganic materials or metals may be employed as the deposition material 121. In particular, Al among the metals has a low work function so that it can be used to form an electrode.

Metals or non-metals may be employed as the additive material 123. A high temperature heat source is required to only evaporate the deposition material 122 for film formation, so that the film formation material 140 mixed with the deposition material 122 and the additive material 123 can be used to form the thin film in the present invention.

In this case, a material having a eutectic melting point with the deposition material 122 is used as the additive material 123. The eutectic melting point means a point that two components do not make a solid solution on a curve of solid and liquid crystal phases of the two components but are completely melted and mixed.

When Al is employed as the deposition material 122, any one of Si, Mg, and Ca is preferably used as the additive material 123. A melting point of Al is about 660°C, and Al is generally melted at a temperature of about 1200°C to about 1400°C to carry out the deposition. Accordingly, the film formation can be carried out at a quite lower temperature by mixing and depositing the additive material 123 having a eutectic melting point with the Al. various materials having a eutectic melting point with the deposition material 122 may be used as the additive material 123 besides the above-described examples.

The film formation material 140 in which Al used as the deposition material 122, and any one of Si, Mg, and Ca used as the additive material 123 are mixed may be deposited to form an Al alloy as the thin film. That is, an Al-Si alloy, an Al-Mg alloy, and an Al-Ca alloy can be formed, respectively. The Al alloy has good mechanical and electrical properties so that it can be used as an electrode. In particular, it is preferably used as a cathode electrode.

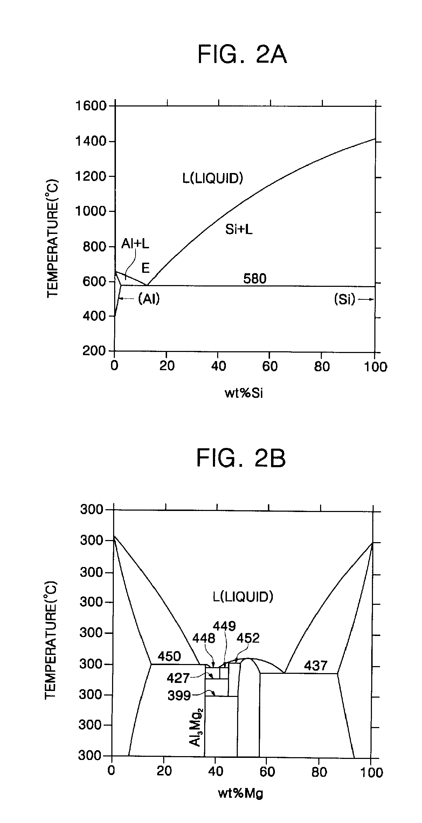

FIGs. 2A to 2C are phase diagrams of film formation materials mixed with a deposition material and an additive material according to the present invention. An x-axis denotes a weight percent wt% of each component and a y-axis denotes a centigrade temperature in each of the phase diagrams.

Referring to FIG. 2A, a phase diagram of the film formation material 140, that is, a material mixed with Al as the deposition material 122 and Si as the additive material is illustrated.

As can be seen from the phase diagram, one eutectic melting point is present in the Al-Si alloy. The eutectic melting point of the Ai-Si alloy is 580°C, and a composition ratio of Al and Si is about 13/97 wt%.

That is, when Si as the additive material is added to Al, the eutectic melting point of the Al-Si alloy becomes 580°C, so that Al can be melt at a temperature quite lower than 660°C as its own melting point. Accordingly, the film formation material containing Al can be deposited at a quite lower temperature according to the present invention compared to a conventional case of depositing Al at a temperature of about 1200°C to about 1400°C.

In this case, a thin film to be formed is composed of an Al-Si alloy. The Al-Si alloy has a low coefficient of expansion, a good wear resistant property, high temperature strength, and a mechanical processing property. The Al-Si alloy can be used as an electrode, and is preferably used as a cathode electrode.

Referring to FIG. 2B, a phase diagram of the film formation material 140, that is, a material mixed with Al as the deposition material 122 and Mg as the additive material is illustrated.

As can be seen from the phase diagram, there are five eutectic melting points in the Al-Mg alloy. Eutectic points of the AI-Mg alloy represent 450°C, 448°C, 449°C, 452°C, and 437°C in response to respective composition ratios of Al and Mg. Accordingly, Al can be melted at a quite lower temperature than 660 as its own melting point, so that the film formation material containing Al can be deposited at a low temperature.

In this case, the thin film to be formed has a good corrosion resistant property and has less change depending on the temperature.

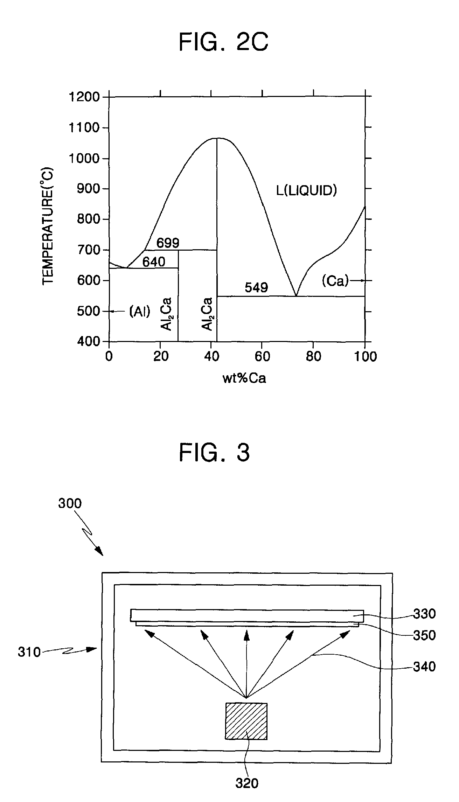

Referring to FIG. 2C, a phase diagram of the film formation material 140, that is, a material mixed with Al as the deposition material 122 and Ca as the additive material is illustrated.

As can be seen from the phase diagram, there are three eutectic melting points in the Al-Ca alloy. Eutectic points of the Al-Ca alloy represent 640°C, 699°C, and 549°C in response to respective composition ratios of Al and Ca. When the composition ratio of Ca is about 92wt% or 26wt%, the respective eutectic melting points thereof are 640°C and 549°C. Accordingly, Al can be melted at a quite lower temperature than 660 as its own melting point, so that the film formation material containing Al can be deposited at a low temperature.

FIG. 3 is a schematic view illustrating a method of fabricating an OLED according to the present invention.

Referring to FIG. 3, a first electrode is formed on a substrate 330. A thin film transistor, and a passivation layer and a planarization layer formed on the thin film transistor may be present on the substrate 330.

The first electrode may be an anode electrode, and a transparent electrode such as an Indium Tin Oxide (ITO) or an Indium Zinc Oxide (IZO) having a high work function may be used as the first electrode. A material having a work function of 5.0eV or more is preferably used as the anode electrode. The work function means a minimum work required to emit electrons within a metal to the exterior.

An organic layer pattern is formed on the first electrode. The organic layer pattern includes at least an organic light emitting layer. In addition, the organic layer pattern may be a single layer of one kind comprised of an organic light emitting layer, or a multi layer of at least two kinds selected from a group consisting of a hole injection layer, a hole transport layer, an electron transport layer, and an electron injection layer in addition to the organic light emitting layer.

A second electrode is formed on the organic layer pattern, thereby completing formation of the OLED. The second electrode may be a cathode electrode, and a material having a low work function is preferably used as the second electrode. A metal material such as Mg, Ca, Al, and Ag may be used as the material having a low work function.

A work function of each of the metal materials Al, Ca, Mg, and Ag is 4.06- 4.41 eV, 2.87~3.00eV, 3.46eV, and 4.26∼4.74eV, respectively.

In this case, at least one of the first and second electrodes may be formed using a vacuum deposition method. A vacuum deposition apparatus 300 used for the vacuum deposition method is composed of a vacuum deposition chamber 310, an evaporation source 320, a substrate 330, and so forth. A process of forming a thin film 350 such as the first or second electrode by depositing the film formation material 340 on the substrate 330 is the same as the descriptions of FIGs. 1Aand 1B.

Referring back to FIG. 1B, an inorganic material or a metal may be used as the deposition material 122.

The additive material 123 is mixed with the deposition material 122, and a metal or a nonmetal may be used as the additive material 123. In this case, a material having a eutectic melting point with the deposition material 122 is used as the additive material 123. The eutectic melting point is described in detail with reference to FIGs. 2A to 2C.

The second electrode may be a cathode electrode, and Al having a low work function (4.06~4.41eV) may be used as the deposition material 122 forming the cathode electrode.

In this case, one material of Si, Mg, and Ca which have eutectic melting points with the deposition material 122 is preferably used as the additive material 123. In addition, the cathode electrode should have a low work function so that a material having a work function close to or less than the work function of Al (4.06~4.41 eV) is preferably used.

Mg and Ca have work functions of 2.87~3.00eV, and 3.46eV, respectively, and Si also has a low work function so that it can used with Al as the cathode electrode. Besides these components, various materials having a eutectic melting point with the deposition material 122 and a work function close to each other may be used as the additive material 123.

Accordingly, it is possible to form the cathode electrode at a quite lower temperature compared to the case of depositing only Al.

In addition, the cathode electrode formed by the deposition is composed of an Al alloy, and an Al-Si alloy, an Al-Mg alloy, an Al-Ca alloy or the like may be formed depending on the additive material 123. The Al alloy has good mechanical and electrical properties so that mechanical and electrical properties of the cathode electrode can be enhanced.

The embodiments of the present invention have been described only for an active matrix OLED, however, the present invention is not limited thereto but may be applied to a passive matrix OLED.

According to the present invention as described above, in addition to a deposition material as a material of forming a thin film, an additive material having a eutectic melting point with the deposition material is mixed with the deposition material. Accordingly, it is possible to form films at a quite lower temperature compared to a conventional case of forming the films using only a deposition material. That is, a high temperature heat source is not required. In addition, mechanical and electrical properties of a thin film, in particular, a cathode electrode of an OLED can be enhanced.

Although the present invention has been described with reference to certain exemplary embodiments thereof, it will be understood by those skilled in the art that a variety of modifications and variations may be made to the present invention without departing from the spirit or scope of the present invention defined in the appended claims, and their equivalents.

## Claims

1. A method of forming a thin film, comprising:
depositing a film formation material mixed with a deposition material and an additive material to form the thin film,
wherein the additive material has a eutectic melting point with the deposition material.

2. The method according to claim 1, wherein the deposition material is a metal material or an inorganic material.

3. The method according to claim 2, wherein the deposition material is aluminum (Al).

4. The method according to claim 3, wherein the additive material is a metal material or a non-metal material.

5. The method according to claim 4, wherein the additive material is one material of silicon (Si), magnesium (Mg), and calcium (Ca).

6. The method according to claim 1, wherein the thin film is formed using a vacuum deposition method.

7. A method of fabricating an organic light emitting display device (OLED), comprising:
forming a first electrode on a substrate;
forming an organic layer pattern including at least an organic light emitting layer on the first electrode; and
forming a second electrode on the organic layer pattern,
wherein at least one of the first and second electrodes is formed by depositing a film formation material mixed with a deposition material and an additive material having a eutectic melting point with the deposition material.

8. The method according to claim 7, wherein the deposition material is a metal material or an inorganic material.

9. The method according to claim 8, wherein the deposition material forming the second electrode is aluminum (Al).

10. The method according to claim 9, wherein the second electrode is a cathode electrode.

11. The method according to claim 10, wherein the additive material is a metal material or a non-metal material.

12. The method according to claim 11, wherein the additive material has a work function equal to or less than a work function of the aluminum (Al).

13. The method according to claim 11, wherein the additive material is one of silicon (Si), magnesium (Mg), and calcium (Ca).

14. The method according to claim 7, wherein at least one of the first and second electrodes is formed using a vacuum deposition method.
